# EUROPEAN PATENT APPLICATION

(11) **EP 4 044 236 A1**
(43) Date of publication of application: **17.08.2022**
(21) Application number: 20877565.0
(22) Date of filing: 31.08.2020
(51) Int. Cl.: H01L 27/15, H01L 33/00, H01L 33/62

(54) **µLED LIGHT-EMITTING AND DISPLAY DEVICE WITHOUT ELECTRICAL CONTACT, EXTERNAL CARRIER INJECTION OR MASS TRANSFER, AND METHOD FOR PREPARING SAME**

(30) Priority: 16.10.2019 CN 201910984750
(71) Applicant: Fu Zhou University, Fuzhou, Fujian 350108 (CN); Mindu Innovation Lab, Fuzhou, Fujian 350108 (CN)
(72) Inventor: GUO, Tailiang, Fuzhou Fujian 350108 (CN); WANG, Kun, Fuzhou Fujian 350108 (CN); WU, Chaoxing, Fuzhou Fujian 350108 (CN); LI, Dianlun, Fuzhou Fujian 350108 (CN); ZHANG, Yongai, Fuzhou Fujian 350108 (CN); ZHOU, Xiongtu, Fuzhou Fujian 350108 (CN); LIU, Ye, Fuzhou Fujian 350108 (CN)
(74) Representative: Bayramoglu et al.
(86) International application number: PCT/CN2020/112401
(87) International publication number: WO 2021/073287

(57) **Abstract**

The present invention relates to a µLED light-emitting and display device without electrical contact, external carrier injection and mass transfer and a preparation method thereof. The µLED light-emitting and display device includes one or more light-emitting pixels, and each light-emitting pixel includes a pixel lower electrode, a lower insulation layer, a µLED chip, an upper insulation layer and a pixel upper electrode from bottom to top, wherein the upper insulation layer and the lower insulation layer prevent the µLED chip from being in direct electrical contact with the pixel lower electrode and the pixel upper electrode, and the µLED chip is lit by an alternating electric field through electromagnetic coupling. In the present invention, the µLED chip is not in electrical contact with a driving electrode, such that a structure of the µLED chip may be simplified, a µLED chip array may be disposed in a manner such as ink-jet printing, screen printing, spin coating, brush coating, roll coating or chemical self-assembly, the use of a mass transfer process and a complex bonding process of the µLED chip and a driving array may be avoided, a manufacturing period of the µLED device is effectively shortened and manufacturing costs are reduced, and it is expected to enhance the market competitiveness of the µLED.

## Description

### BACKGROUND OF THE INVENTION

### 1. Technical Field

The present invention relates to the field of light-emitting and display device design, and in particular to a µLED light-emitting and display device without electrical contact, external carrier injection and mass transfer and a preparation method thereof.

### 2. Description of Related Art

In the field of panel display technologies, micro light emitting diodes (µLED) have many advantages, most notably, such as low power consumption, high luminance, ultra-high definition, high color saturation, faster response, longer service life, and higher operation efficiency. The µLED is a reformed novel display technology that is expected to replace almost all other applications of TFT liquid crystal displays in the field of panel display.

At present, the traditional method for manufacturing an LED is continued as a production process of the µLED, which includes: growing a PN junction on a basic surface by various methods for growing a thin film, and then cutting the PN junction into micron-scale LED chips, and transferring the chips with different light-emitting colors to a circuit substrate by use of various mechanical tools to realize accurate electrical contact between the µLED chip and a driving electrode through accurate alignment and bonding. Such a process consumes a large amount of time and is low in efficiency since a huge number of µLED chips need to be picked up, placed and bonded. In addition, the traditional µLED chip is manufactured with an N contact electrode and a P contact electrode to realize the injection of external carriers. However, direct contact resistance between the electrode and a semiconductor layer of the µLED chip may increase a threshold voltage of the device and generates Joule heat during operation. To solve the above problems and improve the efficiency of the µLED industry, it is urgent to develop and design a new µLED.

### BRIEF SUMMARY OF THE INVENTION

In view of this, an object of the present invention is to provide a µLED light-emitting and display device without electrical contact, external carrier injection and mass transfer and a preparation method thereof, which can avoid the use of a mass transfer process and a complex bonding process of a µLED chip and a driving array, and effectively shorten a manufacturing period of the µLED device and reduce manufacturing costs, and are expected to enhance the market competitiveness of the µLED.

The present invention is realized through the following technical solution. A µLED light-emitting and display device without electrical contact, external carrier injection and mass transfer includes one or more light-emitting pixels, and each light-emitting pixel includes a pixel lower electrode, a lower insulation layer, a µLED chip, an upper insulation layer and a pixel upper electrode from bottom to top, wherein the upper insulation layer and the lower insulation layer can prevent the µLED chip from being in direct electrical contact with the pixel lower electrode and the pixel upper electrode, and the µLED chip is lit by an alternating electric field through electromagnetic coupling. An intensity and polarity of the alternating electric field changes over time, wherein the pixel lower electrode and the pixel upper electrode include a connection line attached thereto and a driving module.

There is no direct electrical contact between the pixel electrode and the µLED chip, and the alternating electric field drives periodic oscillation of an electron-hole pair inside the µLED through electromagnetic coupling to form radiative recombination luminescence.

Further, the µLED chip includes a P-type semiconductor layer, a light emitting layer (multi-quantum well) and an N-type semiconductor layer that are stacked to form a semiconductor junction that can emit light under the action of the electric field.

Further, the semiconductor junction in the µLED chip includes but is not limited to a single PN junction, a single heterojunction, a composite PN junction including a plurality of PN junctions or a combined semiconductor junction including a PN junction and a heterojunction.

Further, the semiconductor junction is located on a surface or in an interior of the µLED chip.

Further, a thickness of the P-type semiconductor layer ranges from 1 nm to 2.0 µm, a thickness of the light emitting layer ranges from 1 nm to 1.0 µm, and a thickness of the N-type semiconductor layer ranges from 1 nm to 2.5 µm.

Further, a size of the µLED chip ranges from 1 nm to 1000 µm, and a thickness of the µLED chip ranges from 1 nm to 100 µm.

Further, the µLED chip emits light in different colors including infrared light or ultraviolet light by selecting different semiconductor materials.

Further, the µLED chip can emit light in the same color or in different mixed colors by adopting the composite PN junction or the combined semiconductor junction.

Further, there are one or more µLED chips in each pixel. When there are more than one µLED chips, all µLED chips are located on the same horizontal plane, and neither of sizes of the pixel upper electrode and the pixel lower electrode in one pixel is less than a sum of sizes of all µLED chips in the pixel.

Further, at least one of the pixel upper electrode and the pixel lower electrode is a transparent electrode, such that the device may be transparent at both sides, or may be transparent at one side and non-transparent at the other side.

A material of the transparent electrode includes but is not limited to graphene, indium tin oxide, a carbon nanotube, a silver nanowire, a copper nanowire or a combination thereof; a material of a non-transparent electrode includes but is not limited to gold, silver, aluminum, copper or a combination thereof.

Further, light transmittance of the upper insulation layer or the lower insulation layer in a visible light range is greater than or equal to 80%, and a material thereof includes an organic insulation material, an inorganic insulation material, air or a combination thereof.

Further, thicknesses of the upper insulation layer and the lower insulation layer both range from 1 nm to 1000 µm.

Further, the upper insulation layer and the lower insulation layer are both deposited on a surface of the µLED chip. Optionally, the upper insulation layer and the lower insulation layer are deposited on surfaces of the pixel upper electrode and the pixel lower electrode respectively.

Further, a voltage waveform of the alternating electric field includes but is not limited to a sine wave, a triangle wave, a square wave, a pulse or a combination thereof. A voltage frequency of the alternating electric field ranges from 1 Hz to 1000M Hz.

Further, the µLED light-emitting and display device is manufactured on a rigid material including glass or ceramics, or manufactured on a flexible material including PI.

The present invention further provides a method for preparing the µLED light-emitting and display device without electrical contact, external carrier injection and mass transfer as described above. Specifically, the method includes the following steps.

In S1, a self-supporting µLED chip is obtained by growing an LED thin film structure that can generate a light source in three primary colors, i.e., red, green and blue on a surface of a semiconductor substrate and forming a µLED chip pattern with a desired size by cutting and peeling.

In S2, a lower electrode array of a sub-pixel having three primary colors, i.e., red, green and blue, a thin film transistor driving array, and an electrical connection line therebetween are prepared on the surface of the substrate according to size and definition requirements of a display.

In S3, non-electrical contact between the µLED chip and a corresponding sub-pixel lower electrode is realized through an insulation layer preparation process by disposing red, green and blue µLED chips on a surface of the lower electrode of the sub-pixel having three primary colors, i.e., red, green and blue correspondingly and respectively.

In S4, non-electrical contact between the µLED chip and a corresponding sub-pixel upper electrode is realized through the insulation layer preparation process by disposing a pixel upper electrode and an electrical connection line thereof on the surface of the substrate provided with red, green and blue µLED chips, so as to obtain a µLED light-emitting and display device without electrical contact, external carrier injection and mass transfer.

The operation of the µLED device is realized by applying an AC driving signal on the pixel upper electrode and the thin film transistor array.

Further, the substrate is a rigid material including glass or ceramics, or a flexible material including PI.

Further, in S3, the red, green and blue µLED chips are disposed at desired positions respectively in a manner of ink-jet printing, screen printing, spin coating, brush coating, roll coating, chemical self-assembly, or electromagnetic self-assembly.

Further, in S3, realizing the non-electrical contact between the µLED chip and the corresponding sub-pixel lower electrode through the insulation layer preparation process specifically includes: realizing the non-electrical contact between the µLED chip and a pixel lower electrode by firstly preparing an insulation layer on a surface of a pixel lower electrode array, and then disposing the µLED chip on a surface of the insulation layer.

Optionally, in S3, realizing the non-electrical contact between the µLED chip and the corresponding sub-pixel lower electrode through the insulation layer preparation process specifically includes: realizing the non-electrical contact between the µLED chip and a pixel lower electrode by wrapping an insulation layer on a surface of the µLED chip, and then preparing the µLED chip wrapped with the insulation layer on a surface of the pixel lower electrode.

Further, in S4, the pixel upper electrode and the electrical connection line thereof are prepared by lamination or growth.

Further, in S4, realizing the non-electrical contact between the µLED chip and the corresponding sub-pixel upper electrode through the insulation layer preparation process specifically includes: realizing the non-electrical contact between the µLED chip and the pixel upper electrode by firstly depositing an insulation layer on a surface of the µLED chip, and then preparing the pixel upper electrode on a surface of the insulation layer.

Optionally, in S4, realizing the non-electrical contact between the µLED chip and the corresponding sub-pixel upper electrode through the insulation layer preparation process specifically includes: realizing the non-electrical contact between the µLED chip and the pixel upper electrode by firstly preparing an insulation layer on a surface of the pixel upper electrode, and then manufacturing the upper electrode and the insulation layer on a surface of the µLED chip through a lamination technology.

Compared to the prior art, the present invention achieves the following beneficial effects. In the present invention, there is no direct electrical contact between the µLED chip and the external driving electrode, and no external carrier is injected into the µLED chip, such that a structure of the µLED chip may be simplified, a µLED chip array may be disposed in a manner such as ink-jet printing, screen printing, spin coating, brush coating, roll coating or chemical self-assembly, the use of a mass transfer process and a complex bonding process of the µLED chip and the driving array can be avoided, and a manufacturing period of the µLED device is effectively shortened and manufacturing costs are reduced, thereby enhancing the market competitiveness of the µLED.

### BRIEF DESCRIPTION OF THE SEVERAL VIEWS OF THE DRAWINGS

FIG. 1 is a sectional view of a light-emitting pixel in a µLED light-emitting and display device without electrical contact, external carrier injection and mass transfer according to an embodiment of the present invention.
FIG. 2 is a sectional view of a light-emitting pixel in another µLED light-emitting and display device without electrical contact, external carrier injection and mass transfer according to an embodiment of the present invention.
FIG. 3 illustrates a process of preparing the light-emitting pixel in FIG. 1.
FIG. 4 illustrates another process of preparing the light-emitting pixel in FIG. 1.
FIG. 5 to FIG. 7 illustrate a process of preparing a µLED light-emitting and display device without electrical contact, external carrier injection and mass transfer with the light-emitting pixel in FIG. 1.

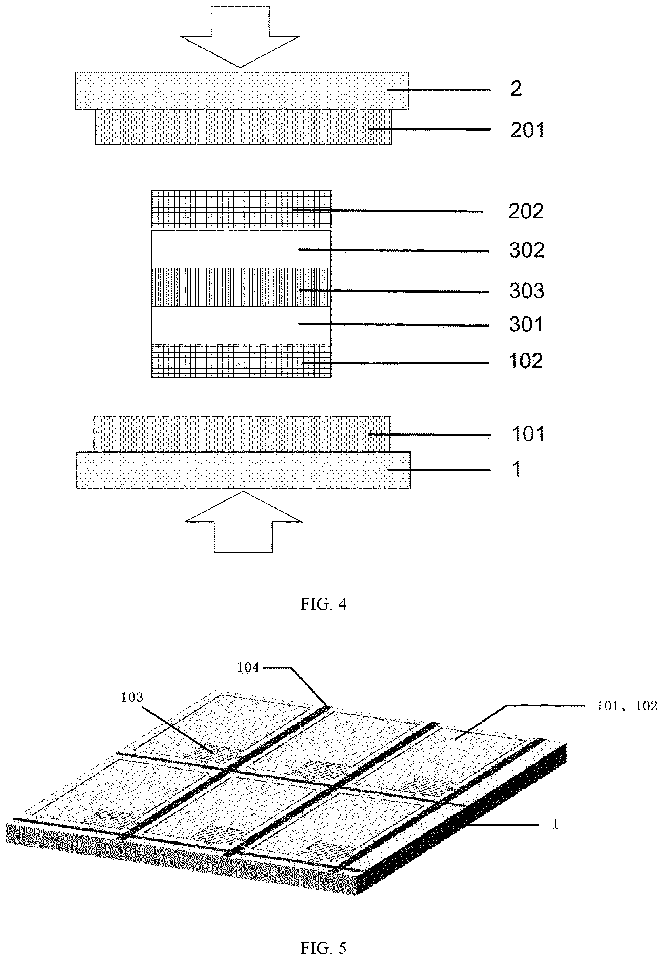

FIG. 5 is a schematic diagram of a lower substrate.

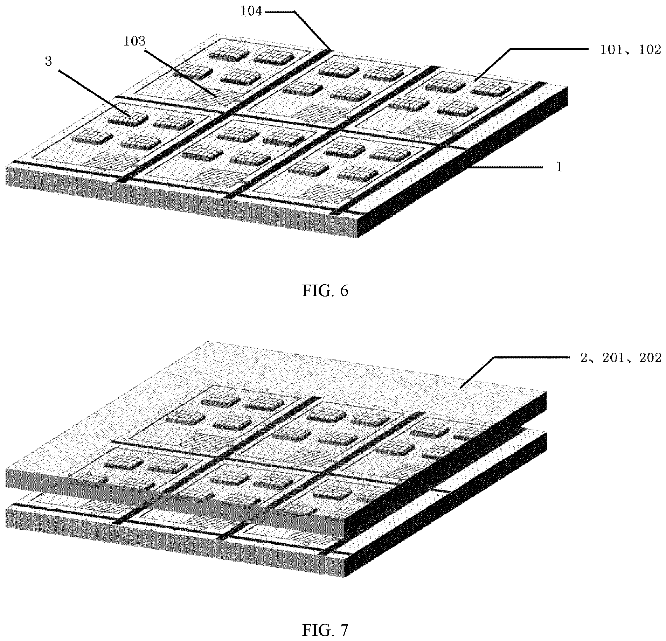

FIG. 6 is a schematic diagram of a lower substrate on which a µLED is prepared.
FIG. 7 is a schematic diagram of a µLED light-emitting and display device.

Numerals in the drawings are described as follows: 1 represents to a lower substrate, 101 represents a pixel lower electrode disposed on a surface of the lower substrate, 102 represents a lower insulation layer, 103 represents a thin film transistor driving array disposed on the surface of the lower substrate, 104 represents an electrode connection line disposed on the surface of the lower substrate, 2 represents an upper substrate, 201 represents a pixel upper electrode disposed on a surface of the upper substrate and an electrode connection line, 202 represents an upper insulation layer, 3 represents a µLED chip, 301 represents a P-type semiconductor layer, 302 represents an N-type semiconductor layer, 303 and 304 both represent a light emitting layer, and 305 represents a P-type semiconductor layer.

### DETAILED DESCRIPTION OF THE INVENTION

The present invention will be further described below in combination with accompanying drawings and embodiments.

It should be noted that, the following detailed descriptions are all exemplary, and are intended to provide further explanation of the present invention. All technical and scientific terms used herein have the same meaning as commonly understood by those of ordinary skills in the art, unless otherwise indicated.

It is to be noted that, the terms used herein are for the purpose of describing the specific embodiments only, and are not intended to limit the exemplary embodiments of the present invention. For example, singular forms used herein are also intended to include plural forms, unless otherwise clearly indicated in the context. In addition, it should also be understood that the terms "comprise" and/or "include" used in the present specification indicate the presence of features, steps, operations, devices, components and/or combinations thereof.

An embodiment of the present invention provides a µLED light-emitting and display device without electrical contact, external carrier injection and mass transfer. The µLED light-emitting and display device includes one or more light-emitting pixels, and each light-emitting pixel includes a pixel lower electrode, a lower insulation layer, a µLED chip, an upper insulation layer and a pixel upper electrode from bottom to top, wherein the upper insulation layer and the lower insulation layer can prevent the µLED chip from being in direct electrical contact with the pixel lower electrode and the pixel upper electrode, and the µLED chip is lit by an alternating electric field through electromagnetic coupling. An intensity and polarity of the alternating electric field changes over time, wherein the pixel lower electrode and the pixel upper electrode include a connection line attached thereto and a driving module.

In this embodiment, there is no direct contact between the pixel electrode and the µLED chip, and the µLED chip is lit by an AC driving signal through electrical coupling. An insulation material is filled between the µLED chip and the driving electrode, and the external alternating electric field drives periodic oscillation of an electron-hole pair inside the µLED to form radiative recombination in a light emitting region.

In this embodiment, the µLED chip includes a P-type semiconductor layer, a light emitting layer (multi-quantum well) and an N-type semiconductor layer that are stacked to form a semiconductor junction that can emit light under the action of the electric field.

In this embodiment, the semiconductor junction in the µLED chip includes but is not limited to a single PN junction, a single heterojunction, a composite PN junction including a plurality of PN junctions or a combined semiconductor junction including a PN junction and a heterojunction.

In this embodiment, the semiconductor junction is located on a surface or in an interior of the µLED chip.

In this embodiment, a thickness of the P-type semiconductor layer ranges from 1 nm to 2.0 µm, a thickness of the light emitting layer ranges from 1 nm to 1.0 µm, and a thickness of the N-type semiconductor layer ranges from 1 nm to 2.5 µm.

In this embodiment, a size of the µLED chip ranges from 1 nm to 1000 µm, and a thickness of the µLED chip ranges from 1 nm to 100 µm.

In this embodiment, the µLED chip emits light in different colors including infrared light or ultraviolet light by selecting different semiconductor materials.

In this embodiment, the µLED chip can emit light in the same color or in different mixed colors by adopting the composite PN junction or the combined semiconductor junction.

In this embodiment, there are one or more µLED chips in each pixel. When there are more than one µLED chips, all µLED chips are located on the same horizontal plane, and neither of sizes of the pixel upper electrode and the pixel lower electrode in one pixel is less than a sum of sizes of all µLED chips in the pixel.

In this embodiment, at least one of the pixel upper electrode and the pixel lower electrode is a transparent electrode, such that the device may be transparent at both sides, or may be transparent at one side and non-transparent at the other side.

A material of the transparent electrode includes but is not limited to graphene, indium tin oxide, a carbon nanotube, a silver nanowire, a copper nanowire or a combination thereof; a material of a non-transparent electrode includes but is not limited to gold, silver, aluminum, copper or a combination thereof.

In this embodiment, light transmittance of the upper insulation layer or the lower insulation layer in a visible light range is greater than or equal to 80%, and a material thereof includes an organic insulation material, an inorganic insulation material, air or a combination thereof.

In this embodiment, thicknesses of the upper insulation layer and the lower insulation layer both range from 1 nm to 1000 µm.

In this embodiment, the upper insulation layer and the lower insulation layer are both deposited on the surface of the µLED chip. Optionally, the upper insulation layer and the lower insulation layer are deposited on surfaces of the pixel upper electrode and the pixel lower electrode respectively.

In this embodiment, a voltage waveform of the alternating electric field includes but is not limited to a sine wave, a triangle wave, a square wave, a pulse or a combination thereof. A voltage frequency of the alternating electric field ranges from 1 Hz to 1000M Hz.

In this embodiment, the µLED light-emitting and display device is manufactured on a rigid material including glass or ceramics, or manufactured on a flexible material including PI.

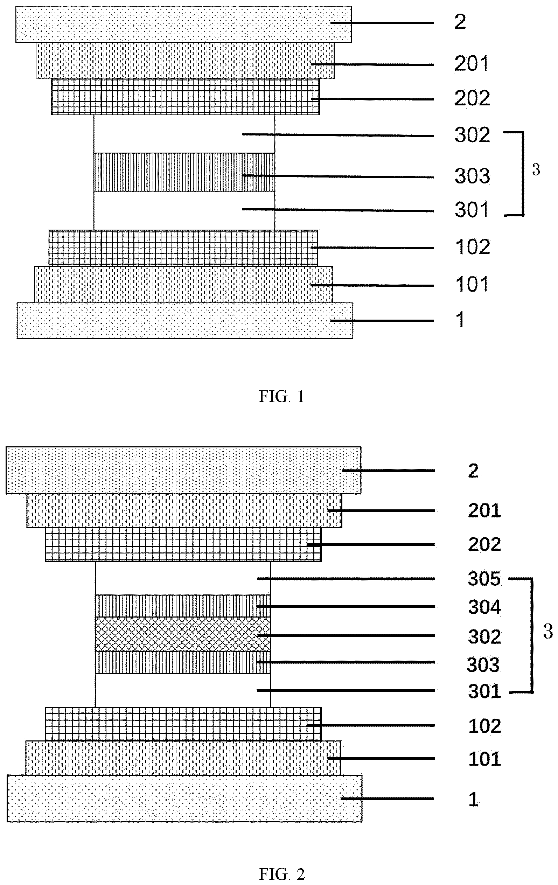

FIG. 1 illustrates a single light emitting unit (pixel) structure in this embodiment, wherein the µLED chip has a semiconductor junction with a single structure of P-type semiconductor layer - multi-quantum well - N-type semiconductor layer. The µLED3 is, for example, a GaN-based LED that is formed by an epitaxial method and includes an N-doped GaN layer 302, a P-doped GaN layer 301 and a multi-quantum well light emitting layer 303. A planar size of the µLED3 is 20 µm × 20 µm.

The pixel lower electrode 101 and the pixel upper electrode 201 are made of indium tin oxide, and planar sizes of the pixel lower electrode 101 and pixel upper electrode 201 are 60 µm × 60 µm.

The lower insulation layer 102 is 100 nm in thickness, and made of aluminum oxide.

The upper insulation layer 202 is 100 nm in thickness, and made of aluminum oxide.

When an AC signal is applied between the pixel upper electrode 201 and the pixel lower electrode 101, the µLED3 may emit light.

FIG. 2 illustrates another single light emitting unit (pixel) structure in this embodiment, wherein the µLED chip has a compound semiconductor junction with a structure of P-type semiconductor material - multi-quantum well - N-type semiconductor material - multi-quantum well - P-type semiconductor material. The µLED3 is, for example, a GaN-based LED that is formed by an epitaxial method, has a semiconductor pair junction structure, and includes a P-doped GaN layer 305, an N-doped GaN layer 302, a P-doped GaN layer 301 and multi-quantum well light emitting layers 303 and 304. A planar size of the µLED3 is 20 µm × 20 µm.

The pixel lower electrode 101 and pixel upper electrode 201 are made of indium tin oxide, and planar sizes of the pixel lower electrode 101 and pixel upper electrode 201 are 60 µm × 60 µm.

The lower insulation layer 102 is 100 nm in thickness, and made of aluminum oxide.

The upper insulation layer 202 is 100 nm in thickness, and made of aluminum oxide.

When an AC signal is applied between the pixel upper electrode 201 and the pixel lower electrode 101, the µLED3 may emit light.

An embodiment of the present invention further provides a method for preparing the µLED light-emitting and display device without electrical contact, external carrier injection and mass transfer as described above. Specifically, the method includes the following steps.

In S1, a self-supporting µLED chip is obtained by growing an LED thin film structure that can generate a light source in three primary colors, i.e., red, green and blue on a surface of a semiconductor substrate and forming a µLED chip pattern with a desired size by cutting and peeling.

In S2, a lower electrode array of a sub-pixel having three primary colors, i.e., red, green and blue, a thin film transistor driving array, and an electrical connection line therebetween are prepared on the surface of the substrate according to size and definition requirements of a display.

In S3, non-electrical contact between the µLED chip and a corresponding sub-pixel lower electrode is realized through an insulation layer preparation process by disposing red, green and blue µLED chips on a surface of the lower electrode of the sub-pixel having three primary colors, i.e., red, green and blue correspondingly and respectively.

In S4, non-electrical contact between the µLED chip and a corresponding sub-pixel upper electrode is realized through the insulation layer preparation process by disposing a pixel upper electrode and an electrical connection line thereof on the surface of the substrate provided with red, green and blue µLED chips, so as to obtain a µLED light-emitting and display device without electrical contact, external carrier injection and mass transfer.

The operation of the µLED device is realized by applying an AC driving signal on the pixel upper electrode and the thin film transistor array.

In this embodiment, the substrate is a rigid material including glass or ceramics, or a flexible material including PI.

In this embodiment, in S3, the red, green and blue µLED chips are disposed at desired positions respectively in a manner of ink-jet printing, screen printing, spin coating, brush coating, roll coating, chemical self-assembly, or electromagnetic self-assembly.

In this embodiment, in S3, realizing the non-electrical contact between the µLED chip and the corresponding sub-pixel lower electrode through the insulation layer preparation process specifically includes: realizing the non-electrical contact between the µLED chip and a pixel lower electrode by firstly preparing an insulation layer on a surface of a pixel lower electrode array, and then disposing the µLED chip on a surface of the insulation layer.

Optionally, in S3, realizing the non-electrical contact between the µLED chip and the corresponding sub-pixel lower electrode through the insulation layer preparation process specifically includes: realizing the non-electrical contact between the µLED chip and a pixel lower electrode by wrapping an insulation layer on a surface of the µLED chip, and then preparing the µLED chip wrapped with the insulation layer on a surface of the pixel lower electrode.

In this embodiment, in S4, the pixel upper electrode and the electrical connection line thereof are prepared by lamination or growth.

In this embodiment, in S4, realizing the non-electrical contact between the µLED chip and the corresponding sub-pixel upper electrode through the insulation layer preparation process specifically includes: realizing the non-electrical contact between the µLED chip and the pixel upper electrode by firstly depositing an insulation layer on a surface of the µLED chip, and then preparing the pixel upper electrode on a surface of the insulation layer.

Optionally, in S4, realizing the non-electrical contact between the µLED chip and the corresponding sub-pixel upper electrode through the insulation layer preparation process specifically includes: realizing the non-electrical contact between the µLED chip and the pixel upper electrode by firstly preparing an insulation layer on a surface of the pixel upper electrode, and then manufacturing the upper electrode and the insulation layer on a surface of the µLED chip through a lamination technology.

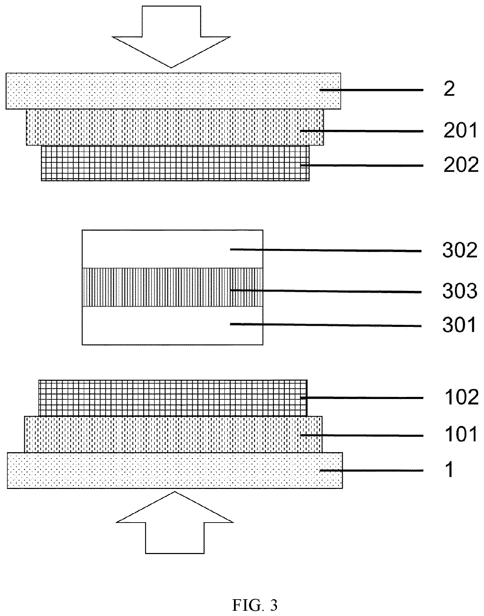

Referring to FIG. 3, which illustrates a preparation method in FIG. 1. Specifically, the insulation layer 102 and the insulation layer 202 are firstly deposited on the surfaces of the pixel lower electrode 101 and the pixel upper electrode 201 through the following steps.

(1) The µLED3 is, for example, a GaN-based LED that is formed by an epitaxial method and includes an N-doped GaN layer 302, a P-doped GaN layer 301 and a multi-quantum well light emitting layer 303. The planar size of the µLED3 is 20 µm × 20 µm.

Optionally, the µLED3 may also be a GaAs-based LED formed by the epitaxial method.

(2) The patterned lower electrode substrate 1 and upper electrode substrate 2 are cleaned and processed respectively. The lower electrode 101 and the upper electrode 201 are made of indium tin oxide, and the planar sizes of the pixel lower electrode 101 and pixel upper electrode 201 are 60 µm × 60 µm.

Optionally, the lower electrode 101 and the upper electrode 201 may also be made of a metal material such as gold, silver, copper and aluminum.

(3) The insulation layer 102 is deposited on the surface of the lower electrode 101 by magnetron sputtering, and the thickness of the insulation layer 102 is 100 nm.

Optionally, the insulation layer 102 may be made of a high-K dielectric material such as aluminum oxide and hafnium oxide; the insulation layer 102 may also be deposited on the surface of the lower electrode 101 by atomic layer deposition, or the like.

(4) The insulation layer 202 is deposited on the surface of the upper electrode 201 by magnetron sputtering, and the thickness of the insulation layer 202 is 100 nm.

Optionally, the insulation layer 202 may be made of a high-K dielectric material such as aluminum oxide and hafnium oxide; the insulation layer 202 may also be deposited on the surface of the upper electrode 201 by atomic layer deposition, or the like.

(5) The µLED3 is transferred to the surface of the lower electrode substrate 1 through a µLED array preparation technology, such that the µLED3 is located on the surface of the insulation layer 102.

Optionally, the µLED array preparation technology includes ink-jet printing, screen printing, spin coating, brush coating, roll coating, chemical self-assembly, electromagnetic self-assembly, and the like.

(6) The upper electrode substrate 2 is assembled on the lower electrode substrate 1, such that the µLED3 is located between the insulation layer 102 and the insulation layer 202. When an AC signal is applied between the upper electrode 201 and the lower electrode 101, the µLED3 may emit light.

Referring to FIG. 4, which illustrates another preparation method in FIG. 1. Specifically, the insulation layer 102 and the insulation layer 202 are firstly deposited on the surfaces of µLED chips 301 and 302 through the following steps.

(1) The µLED3 is, for example, a GaN-based LED that is formed by an epitaxial method and includes an N-doped GaN layer 302, a P-doped GaN layer 301 and a multi-quantum well light emitting layer 303. A self-supporting µLED chip is obtained by peeling. The planar size of the µLED3 is 20 µm × 20 µm.

Optionally, the µLED3 may also be a GaAs-based LED formed by the epitaxial method.

(2) The patterned lower electrode substrate 1 and upper electrode substrate 2 are cleaned and processed respectively. The lower electrode 101 and the upper electrode 201 are made of indium tin oxide, and the planar sizes of the lower electrode 101 and the upper electrode 201 are 60 µm × 60 µm.

Optionally, the lower electrode 101 and the upper electrode 201 may also be made of a metal material such as gold, silver, copper and aluminum.

(3) The insulation layer 102 is deposited on a lower surface of the µLED3 by atomic layer deposition, and the thickness of the insulation layer 102 is 100 nm.

(4) The insulation layer 202 is deposited on an upper surface of the µLED3 by atomic layer deposition, and the thickness of the insulation layer 202 is 100 nm.

Optionally, the insulation layer 102 and the insulation layer 202 may be made of a high-K dielectric material such as aluminum oxide and hafnium oxide.

(5) The µLED3 is transferred to the surface of the lower electrode substrate 1 through a µLED array preparation technology, such that the µLED3 is located on the surface of the insulation layer 102.

Optionally, the µLED array preparation technology includes ink-jet printing, screen printing, spin coating, brush coating, roll coating, chemical self-assembly, electromagnetic self-assembly, and the like.

(6) The upper electrode substrate 2 is assembled on the surface of the lower electrode substrate 1, such that the µLED3 on which the insulation layer 102 and the insulation layer 202 are deposited is located between the upper electrode 201 and the lower electrode 101.

FIG. 5 to FIG. 7 illustrate a method for preparing a µLED light-emitting and display device without electrical contact, external carrier injection and mass transfer in this embodiment. The µLED device includes one or more light-emitting pixels, and the method includes the following steps.

(1) The µLED3 is, for example, a GaN-based LED that is formed by an epitaxial method and includes an N-doped GaN layer 302, a P-doped GaN layer 301 and a multi-quantum well light emitting layer 303. A self-supporting µLED chip is obtained by peeling. The planar size of the µLED3 is 20 µm × 20 µm.

Optionally, the µLED3 may also be a GaAs-based LED formed by the epitaxial method.

(2) As shown in FIG. 5, a patterned indium tin oxide (ITO) pixel array 101, a thin film transistor array 103 and an electrode connection line array 104 thereof are prepared on the surface of the lower substrate 1 through the conventional processes of preparing the patterned ITO electrode, the thin film transistor array and the electrode connection line. A size of the ITO pixel electrode 101 is 60 µm × 60 µm.

(3) The insulation layer 102 is deposited on a surface of the ITO pixel array 101 by atomic layer deposition, and the thickness of the insulation layer 102 is 100 nm.

Optionally, the insulation layer 102 and the insulation layer 202 may be made of a high-K dielectric material such as aluminum oxide and hafnium oxide.

(4) As shown in FIG. 6, the µLED3 is transferred to the surface of the lower electrode substrate 1 through a µLED array preparation technology, such that the µLED3 is located on the surface of the insulation layer 102.

Optionally, the µLED array preparation technology includes ink-jet printing, screen printing, spin coating, brush coating, roll coating, chemical self-assembly, electromagnetic self-assembly, and the like.

(5) The insulation layer 202 is deposited on the surface of the upper substrate electrode 201 by atomic layer deposition, and the thickness of the insulation layer 202 is 100 nm.

(6) As shown in FIG. 7, the upper electrode substrate 2 and the lower electrode substrate 1 are assembled, such that the µLED3 is located between the insulation layer 102 and the insulation layer 202. When an AC signal is applied between the upper electrode 201 and the lower electrode 101, the µLED3 may emit light.

The foregoing descriptions are merely preferred embodiments of the present invention but are not intended to limit the present disclosure in other forms. Any person skilled in the art may change or modify the technical content disclosed above into equivalent embodiments with equivalent changes. However, any simple modifications, equivalent changes and variations made to the above embodiments without departing from the content of the technical solution of the present invention based on the technical essence of the present invention shall be encompassed in the scope of protection of the present invention.

## Claims

1. A µLED light-emitting and display device without electrical contact, external carrier injection and mass transfer, comprising: one or more light-emitting pixels, wherein each light-emitting pixel comprises a pixel lower electrode, a lower insulation layer, a µLED chip, an upper insulation layer and a pixel upper electrode from bottom to top; the upper insulation layer and the lower insulation layer prevent the µLED chip from being in direct electrical contact with the pixel lower electrode and the pixel upper electrode, and the µLED chip is lit by an alternating electric field through electromagnetic coupling.

2. The µLED light-emitting and display device without electrical contact, external carrier injection and mass transfer according to claim 1, wherein the µLED chip comprises a P-type semiconductor layer, a light emitting layer and an N-type semiconductor layer that are stacked to form a semiconductor junction capable of emitting light under the action of the electric field.

3. The µLED light-emitting and display device without electrical contact, external carrier injection and mass transfer according to claim 2, wherein the semiconductor junction in the µLED chip comprises but is not limited to a single PN junction, a single heterojunction, a composite PN junction comprising a plurality of PN junctions or a combined semiconductor junction comprising a PN junction and a heterojunction.

4. The µLED light-emitting and display device without electrical contact, external carrier injection and mass transfer according to claim 2, wherein the semiconductor junction is located on a surface or in an interior of the µLED chip.

5. The µLED light-emitting and display device without electrical contact, external carrier injection and mass transfer according to claim 2, wherein a thickness of the P-type semiconductor layer ranges from 1 nm to 2.0 µm, a thickness of the light emitting layer ranges from 1 nm to 1.0 µm, and a thickness of the N-type semiconductor layer ranges from 1 nm to 2.5 µm.

6. The µLED light-emitting and display device without electrical contact, external carrier injection and mass transfer according to claim 1, wherein a size of the µLED chip ranges from 1 nm to 1000 µm, and a thickness of the µLED chip ranges from 1 nm to 100 µm.

7. The µLED light-emitting and display device without electrical contact, external carrier injection and mass transfer according to claim 2, wherein the µLED chip emits light in different colors comprising infrared light or ultraviolet light by selecting different semiconductor materials.

8. The µLED light-emitting and display device without electrical contact, external carrier injection and mass transfer according to claim 3, wherein the µLED chip is capable of emitting light in the same color or in different mixed colors by adopting the composite PN junction or the combined semiconductor junction.

9. The µLED light-emitting and display device without electrical contact, external carrier injection and mass transfer according to claim 1, wherein there are one or more µLED chips in each pixel.

10. The µLED light-emitting and display device without electrical contact, external carrier injection and mass transfer according to claim 9, neither of sizes of the pixel upper electrode and the pixel lower electrode in one pixel is less than a sum of sizes of all µLED chips in the pixel.

11. The µLED light-emitting and display device without electrical contact, external carrier injection and mass transfer according to claim 1, wherein at least one of the pixel upper electrode and the pixel lower electrode is a transparent electrode, a material of the transparent electrode comprises but is not limited to graphene, indium tin oxide, a carbon nanotube, a silver nanowire, a copper nanowire or a combination thereof, and a material of a non-transparent electrode comprises but is not limited to gold, silver, aluminum, copper or a combination thereof.

12. The µLED light-emitting and display device without electrical contact, external carrier injection and mass transfer according to claim 1, wherein light transmittance of the upper insulation layer or the lower insulation layer in a visible light range is greater than or equal to 80%, and a material thereof comprises an organic insulation material, an inorganic insulation material, air or a combination thereof.

13. The µLED light-emitting and display device without electrical contact, external carrier injection and mass transfer according to claim 1, wherein thicknesses of the upper insulation layer and the lower insulation layer both range from 1 nm to 1000 µm.

14. The µLED light-emitting and display device without electrical contact, external carrier injection and mass transfer according to claim 1, wherein the upper insulation layer and the lower insulation layer are both deposited on a surface of the µLED chip.

15. The µLED light-emitting and display device without electrical contact, external carrier injection and mass transfer according to claim 1, wherein the upper insulation layer and the lower insulation layer are deposited on surfaces of the pixel upper electrode and the pixel lower electrode respectively.

16. The µLED light-emitting and display device without electrical contact, external carrier injection and mass transfer according to claim 1, wherein a voltage waveform of the alternating electric field comprises but is not limited to a sine wave, a triangle wave, a square wave, a pulse or a combination thereof.

17. The µLED light-emitting and display device without electrical contact, external carrier injection and mass transfer according to claim 1, wherein a voltage frequency of the alternating electric field ranges from 1 Hz to 1000M Hz.

18. The µLED light-emitting and display device without electrical contact, external carrier injection and mass transfer according to claim 1, wherein the µLED light-emitting and display device is manufactured on a rigid material comprising glass or ceramics, or manufactured on a flexible material comprising PI.

19. A method for manufacturing the µLED light-emitting and display device without electrical contact, external carrier injection and mass transfer according to any one of claims 1 to 18, comprising the following steps:
in S1, obtaining a self-supporting µLED chip by growing an LED thin film structure capable of generating a light source in three primary colors, i.e., red, green and blue on a surface of a semiconductor substrate and forming a µLED chip pattern with a desired size by cutting and peeling;
in S2, preparing a lower electrode array of a sub-pixel having three primary colors, i.e., red, green and blue, a thin film transistor driving array, and an electrical connection line therebetween on the surface of the substrate;
in S3, realizing non-electrical contact between the µLED chip and a corresponding sub-pixel lower electrode through an insulation layer preparation process by disposing red, green and blue µLED chips on a surface of the lower electrode of the sub-pixel having three primary colors, i.e., red, green and blue correspondingly and respectively; and
in S4, realizing non-electrical contact between the µLED chip and a corresponding sub-pixel upper electrode through the insulation layer preparation process by disposing a pixel upper electrode and an electrical connection line thereof on the surface of the substrate provided with red, green and blue µLED chips, so as to obtain a µLED light-emitting and display device without electrical contact, external carrier injection and mass transfer.

20. The method according to claim 19, wherein in S3, the red, green and blue µLED chips are disposed at desired positions respectively in a manner of ink-jet printing, screen printing, spin coating, brush coating, roll coating, chemical self-assembly, or electromagnetic self-assembly.

21. The method according to claim 19, wherein in S3, realizing the non-electrical contact between the µLED chip and the corresponding sub-pixel lower electrode through the insulation layer preparation process specifically comprises: realizing the non-electrical contact between the µLED chip and a pixel lower electrode by firstly preparing an insulation layer on a surface of a pixel lower electrode array, and then disposing the µLED chip on a surface of the insulation layer.

22. The method according to claim 19, wherein in S3, realizing the non-electrical contact between the µLED chip and the corresponding sub-pixel lower electrode through the insulation layer preparation process specifically comprises: realizing the non-electrical contact between the µLED chip and a pixel lower electrode by wrapping an insulation layer on a surface of the µLED chip, and then preparing the µLED chip wrapped with the insulation layer on a surface of the pixel lower electrode.

23. The method according to claim 19, wherein in S4, the pixel upper electrode and the electrical connection line thereof are prepared by lamination or growth.

24. The method according to claim 19, wherein in S4, realizing the non-electrical contact between the µLED chip and the corresponding sub-pixel upper electrode through the insulation layer preparation process specifically comprises: realizing the non-electrical contact between the µLED chip and the pixel upper electrode by firstly depositing an insulation layer on a surface of the µLED chip, and then preparing the pixel upper electrode on a surface of the insulation layer.

25. The method according to claim 19, wherein in S4, realizing the non-electrical contact between the µLED chip and the corresponding sub-pixel upper electrode through the insulation layer preparation process specifically comprises: realizing the non-electrical contact between the µLED chip and the pixel upper electrode by firstly preparing an insulation layer on a surface of the pixel upper electrode, and then manufacturing the upper electrode and the insulation layer on a surface of the µLED chip through a lamination technology.
